# EUROPEAN PATENT APPLICATION

(11) **EP 2 918 925 A1**
(43) Date of publication of application: **16.09.2015**
(21) Application number: 13853608.1
(22) Date of filing: 11.10.2013
(51) Int. Cl.: F24F 3/044, F24F 7/08

(54) **COOLING DEVICE, AND HEATING ELEMENT HOUSING DEVICE EQUIPPED WITH SAME**

(30) Priority: 12.11.2012 JP 2012248134
(71) Applicant: Panasonic Intellectual Property Management Co., Ltd., Osaka-shi, Osaka 540-6207 (JP)
(72) Inventor: FUNADA, Naoyuki, Osaka-shi, Osaka 540-6207 (JP); KIYOMOTO, Kunio, Osaka-shi, Osaka 540-6207 (JP); SAHASI, Takahiro, Osaka-shi, Osaka 540-6207 (JP); MAEDA, Shogo, Osaka-shi, Osaka 540-6207 (JP)
(74) Representative: Schwabe - Sandmair - Marx
(86) International application number: PCT/JP2013/006079
(87) International publication number: WO 2014/073166

(57) **Abstract**

A cooling device includes body case (3a), outside air fan (14) and inside air fan (17), and heat exchange element (11). The inside of body case (3a) is divided into inside air area (51) and outside air area (52) by element casing (10). Outside air fan (14) is disposed in outside air area (52), and inside air fan (17) adjacent to inside air inlet (6) and heat exchange element (11) adjacent to inside air outlet (7) are disposed in inside air area (51).

## Description

### TECHNICAL FIELD

The present invention relates to a cooling device and a heating element housing device equipped with the same.

### BACKGROUND ART

A base station for mobile phones includes a heating element housing device in which a transmitter and a receiver which form heating elements are housed. An electric current of several tens amperes or more flows through the transmitter and the receiver. Accordingly, in the base station for mobile phones, cooling of the heating element housing device is extremely important for stabilizing the operation of the transmitter and the receiver.

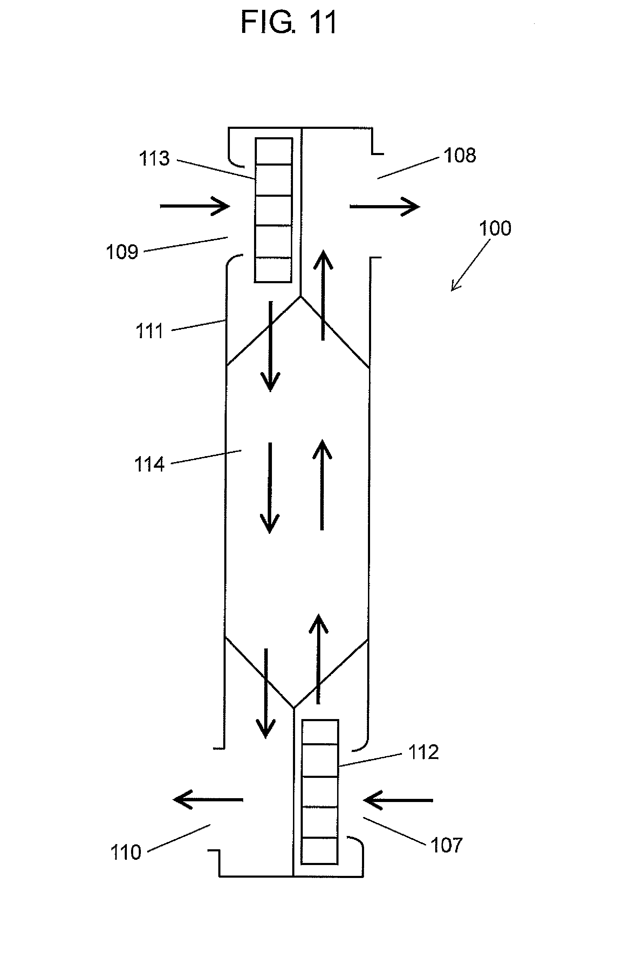

FIG. 11 is a configuration diagram of a conventional cooling device. As shown in FIG. 11, cooling device 100 includes: body case 111; first blower 112 for outside air which is disposed in the inside of body case 111; and second blower 113 for inside air which is disposed in the inside of body case 111; and heat exchanger 114. Body case 111 has: first inlet 107 and first outlet 108 for outside air; and second inlet 109 and second outlet 110 for inside air. Heat exchanger 114 performs heat exchange between outside air and inside air in the inside of body case 111 (see PTL 1, for example).

### Citation List

### Patent Literature

PTL 1: Unexamined Japanese Patent Publication No. 2000-161875

### SUMMARY OF THE INVENTION

In a base station for mobile phones, a cooling device is mounted on a wall surface of a heating element housing device. The conventional cooling device includes the first blower for outside air and the second blower for inside air in the inside of the body case. The cooling device is configured such that the heat exchanger is housed in a state where the cooling device is sandwiched by these two blowers and hence, the body case becomes large-sized. Accordingly, an installation area of the base station for mobile phones where the cooling device is mounted on the wall surface of the heating element housing device also becomes large. However, there has been a demand for installing a base station for mobile phones on a roof of a building, a steel tower or a utility pole and hence, the further reduction of installation area of the base station has been required.

Accordingly, a cooling device of the present invention includes: a body case having an outside air inlet, an outside air outlet, an inside air inlet, and an inside air outlet; an outside air fan and an inside air fan provided in the inside of the body case; and a heat exchange element which performs heat exchange between outside air and inside air in the inside of the body case. The heat exchange element is formed by laminating a plurality of plate bodies at predetermined intervals. Further, the heat exchange element is held by an element casing which divides the inside of the body case into an inside air area into which the inside air is sucked and an outside air area into which the outside air is sucked. The outside air inlet is provided in the outside air area. The inside air inlet and the inside air outlet are provided in an attachment surface of the body case in the inside air area. The outside air fan is disposed in the outside air area. The inside air fan adjacent to the inside air inlet and the heat exchange element adjacent to the inside air outlet are disposed in the inside air area.

In such a cooling device, the inside of the body case is divided into two areas including the outside air area and the inside air area. As a result, it is unnecessary to arrange the outside air fan, the heat exchange element and the inside air fan along one direction and hence, the attachment surface for mounting the cooling device can be reduced, and an area for installing a heating element housing device equipped with the cooling device can be also reduced.

### BRIEF DESCRIPTION OF DRAWINGS

FIG. 1 is a perspective view showing a heating element housing device according to an exemplary embodiment of the present invention.
FIG. 2 is a perspective view of the heating element housing device when a cabinet door is opened.
FIG. 3A is a main elevation view of the cooling device.
FIG. 3B is a cross-sectional view taken along line 3B-3B in FIG. 3A.
FIG. 4 is a perspective view showing an installation example of the heating element housing device according to the exemplary embodiment of the present invention.
FIG. 5A is a perspective view of a body case of the cooling device as viewed from an outside air side.
FIG. 5B is an inner structure view of the cooling device as viewed from the outside air side.
FIG. 6 is a perspective view of the cooling device as viewed from a cabinet side.
FIG. 7 is a view showing the heating element housing device shown in FIG. 1 in a see-through manner as viewed from above in the vertical direction.
FIG. 8 is a schematic view showing the inside of the heating element housing device according to the exemplary embodiment of the present invention as viewed from above in the vertical direction in a case where the cooling device is attached at a different position.
FIG. 9 is a perspective view of a cooling device body of the cooling device according to the exemplary embodiment of the present invention in a state where the outer cover is removed from the cooling device.
FIG. 10 is a schematic view showing the inside of the heating element housing device according to the exemplary embodiment of the present invention as viewed in the horizontal direction in a case where the cooling device is attached at another different position.
FIG. 11 is a configuration diagram of a conventional cooling device.

### DESCRIPTION OF EMBODIMENTS

Hereinafter, an exemplary embodiment of the present invention will be described with reference to the drawings.

### (EXEMPLARY EMBODIMENT)

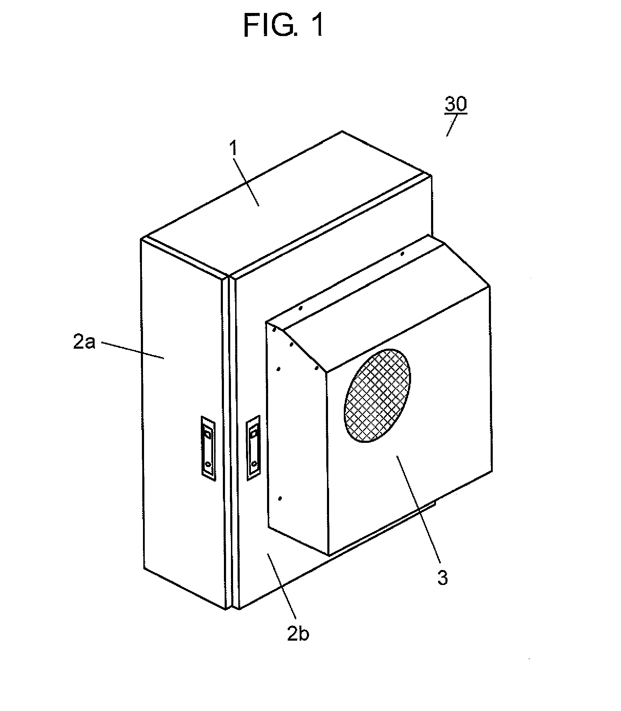

FIG. 1 is a perspective view showing a heating element housing device according to an exemplary embodiment of the present invention. As shown in FIG. 1, in heating element housing device 30, front cabinet door 2a and side cabinet door 2b are openably provided to two surfaces of cabinet 1 respectively. Cooling device 3 is attached to side cabinet door 2b.

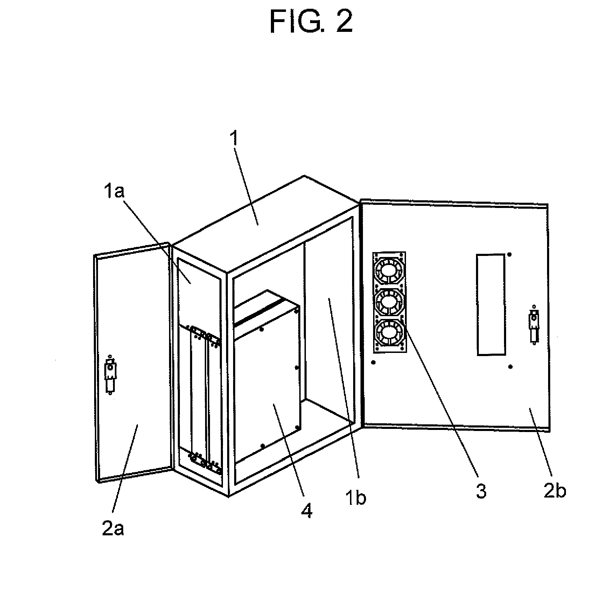

FIG. 2 is a perspective view of the heating element housing device according to the exemplary embodiment of the present invention when a cabinet door is opened. Communication device 4 is disposed in the inside of cabinet 1. Communication device 4 is disposed such that a front surface of communication device 4 is disposed on a front cabinet door 2a side, and an internal printed circuit board is disposed orthogonal to front cabinet door 2a when front cabinet door 2a is in a closed state. That is, when air is supplied to front surface side 1a of cabinet 1, the air flows to rear side 1b of cabinet 1 along the internal printed circuit board of communication device 4. Further, by opening front cabinet door 2a, an operator can perform maintenance of communication device 4 or the like.

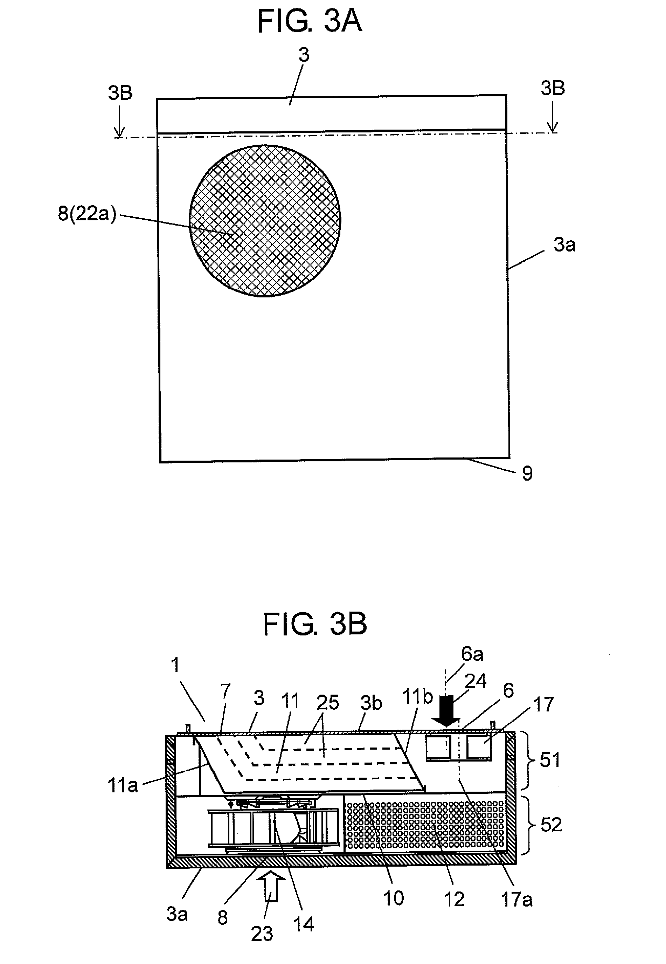

FIG. 3A is a main elevation view of the cooling device according to the exemplary embodiment of the present invention, and FIG. 3B is a cross-sectional view taken along line 3B-3B in FIG. 3A. As shown in FIG. 3A and FIG. 3B, cooling device 3 includes: body case 3a; outside air fan 14; inside air fan 17; and heat exchange element 11. One surface of body case 3a is fixed to cabinet 1. The inside of body case 3a is divided into two areas including inside air area 51 located on a cabinet 1 side and outside air area 52 located on an outside air 23 side by element casing 10. Element casing 10 holds heat exchange element 11. Inside air 24 is sucked into the inside of body case 3a in inside air area 51. On the other hand, outside air 23 is sucked into the inside of body case 3a in outside air area 52.

Inside air inlet 6 and inside air outlet 7 are provided in attachment surface 3b of body case 3a which is fixed to cabinet 1 side. Outside air inlet 8 is provided in body case 3a on a side opposite to attachment surface 3b. Outside air outlet 9 is provided in a bottom surface of body case 3a. Element casing 10 is attached substantially parallel to attachment surface 3b. Attachment surface 3b is a surface configuring inside air area 51.

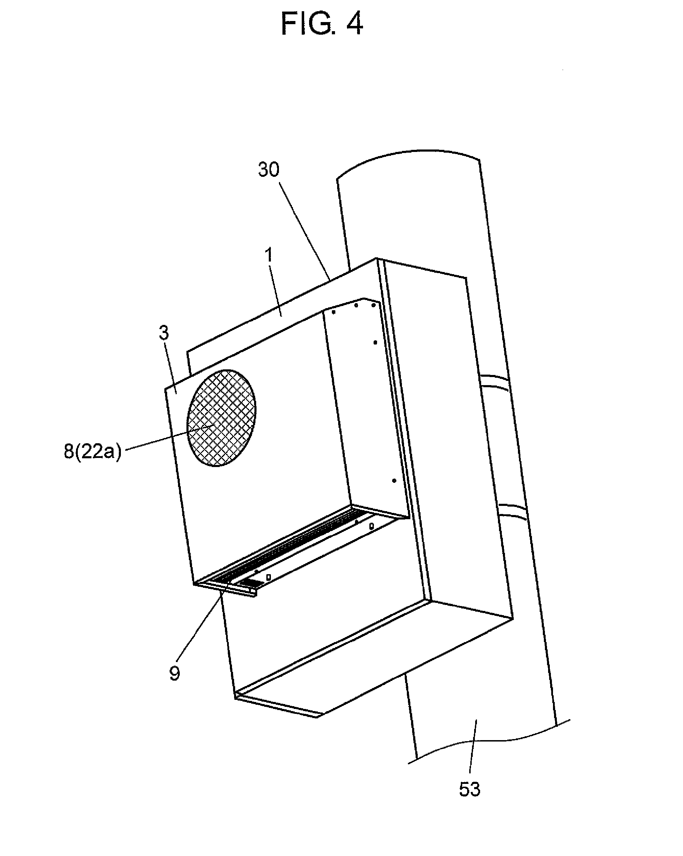

FIG. 4 is a perspective view showing an installation example of the heating element housing device according to the exemplary embodiment of the present invention. FIG. 4 shows a case where heating element housing device 30 is mounted on utility pole 53. Outside air outlet 9 is provided in cooling device 3 by opening a lower surface of body case 3a.

As shown in FIG. 3B, inside air fan 17 adjacent to inside air inlet 6 and heat exchange element 11 adjacent to inside air outlet 7 are provided in inside air area 51. Inside air fan 17 includes an axial-type impeller which is fixed with a suction side of the axial-type impeller directed to inside air inlet 6. Inside air fan 17 is disposed such that inside air fan rotation axis 17a and inside air suction direction 6a of inside air inlet 6 are disposed parallel to each other. Outside air fan 14 and outside air inlet 8 are provided in outside air area 52.

Heat exchange element 11 performs heat exchange between outside air 23 and inside air 24 in the inside of body case 3a. Heat exchange element 11 is formed by laminating a plurality of plate bodies 25 at predetermined intervals. Plate body 25 has a parallelogram shape. Further, plate body 25 is made of a synthetic resin. A plurality of flow straightening walls which partition a surface of plate body 25 into a lane shape are provided on the surface of each plate body 25. The flow straightening wall extends from one end of plate body 25 which forms an inflow port to the other end of plate body 25. The flow straightening wall has a shape which is bent to one long side (a side adjacent to a side on an inflow port side at an obtuse angle) at a position in front of the other end of plate body 25, and is connected to an outflow port.

With the provision of such flow straightening walls, a plurality of air supply lanes each having an approximately L shape are formed on plate body 25. In heat exchange element 11, with respect to inside air 24, short air supply lanes are provided on a cabinet 1 side, and long air supply lanes are provided on an outside air 23 side. On the other hand, with respect to outside air 23, long air supply lanes are provided on the cabinet 1 side, and short air supply lanes are provided on the outside air 23 side. FIG. 3B shows the flow straightening walls which form air supply passages for inside air 24 by dotted lines. The flow straightening walls which form air supply passages for outside air 23 have a shape which is obtained by rotating the flow straightening walls for inside air 24 by 180 degrees about an intersection point of diagonal lines of plate body 25.

In heat exchange element 11 having such a configuration, first inflow port 11a (air inlet for outside air) on an outside air 23 side is formed in one surface of heat exchange element 11, and an outflow port on the outside air 23 side is connected to outside air outlet 9 through outside air chamber 12. Second inflow port 11b (air inlet for inside air) on an inside air 24 side is formed in a surface of heat exchange element 11 which faces first inflow port 11a in an opposed manner. An outflow port on the inside air 24 side is connected to inside air outlet 7. Heat exchange element 11 is pressed to attachment surface 3b by element casing 10.

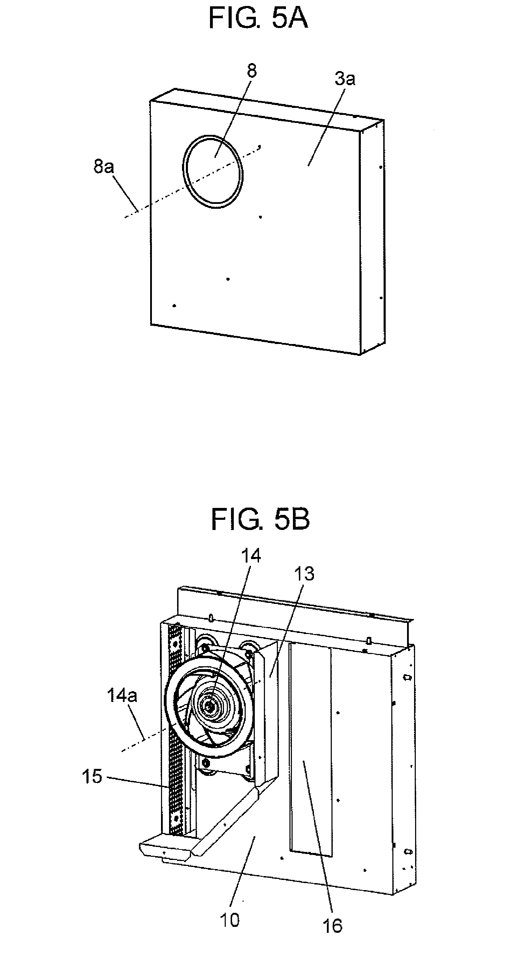

FIG. 5A is a perspective view of the body case of the cooling device according to the exemplary embodiment of the present invention as viewed from an outside air side, and FIG. 5B is an inner structure view of the cooling device as viewed from the outside air side. As shown in FIG. 5A and FIG. 5B, when body case 3a is removed, element casing 10 is exposed. Partition plate 13 which divides the inside of the body case 3a, that is, into an air inlet side and an air outlet side and outside air fan 14 are fixed to element casing 10. Further, outside air ventilation ports 15, 16 are formed on element casing 10. Outside air ventilation port 15 guides outside air 23 blown out by outside air fan 14 to first inflow port 11a of heat exchange element 11 shown in FIG. 3B. Outside air ventilation port 16 guides outside air 23 flown out from an outside air outflow port of heat exchange element 11 shown in FIG. 3B to outside air chamber 12.

Outside air fan 14 is formed using a turbo centrifugal blower. Outside air fan 14 is fixed such that an inlet of outside air fan 14 coincides with outside air inlet 8, and outside air fan rotation axis 14a and outside air suction direction 8a of outside air inlet 8 are disposed parallel to each other.

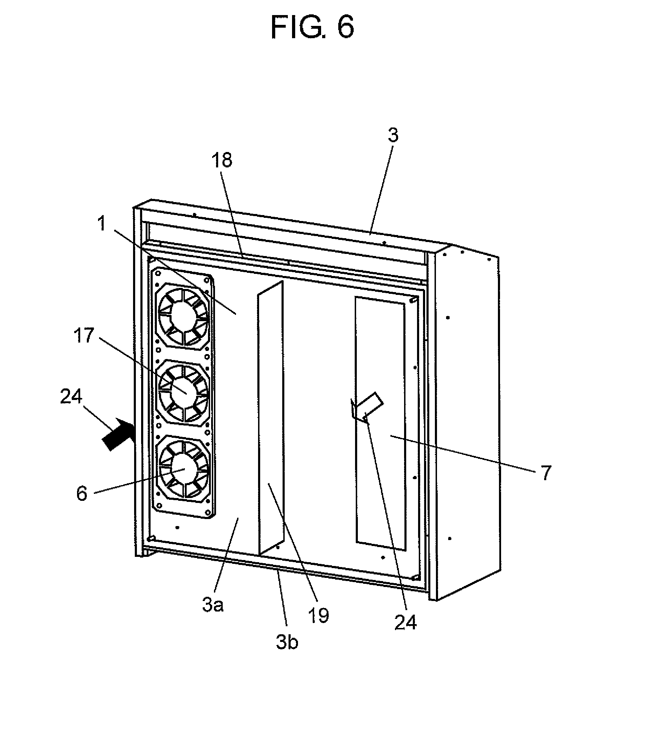

FIG. 6 is a perspective view of the cooling device according to the exemplary embodiment of the present invention as viewed from a cabinet side. FIG. 6 is a view of cooling device 3 as viewed from the cabinet 1 side. Inside air inlet 6 and inside air outlet 7 are formed on body case 3a on a cabinet 1 side. Inside air fans 17 are fixed to the inside of air inlet 6 inside body case 3a. Packing 18 is adhered to the periphery of attachment surface 3b of body case 3a fixed to cabinet 1 for securing airtightness.

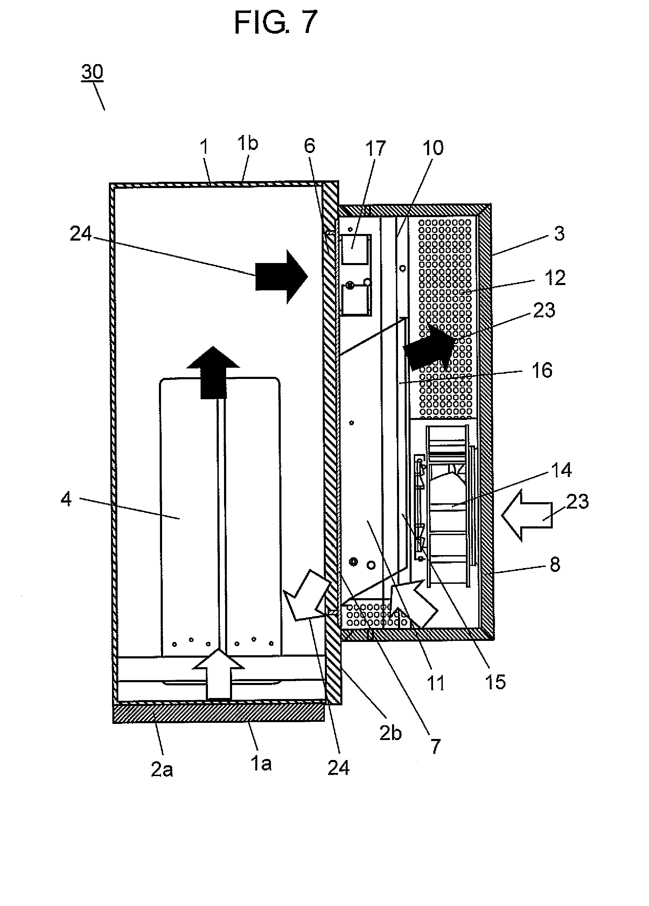

FIG. 7 is a view showing the heating element housing device shown in FIG. 1 in a see-through manner as viewed from above in the vertical direction. In heating element housing device 30 shown in FIG. 7, inside air outlet 7 shown in FIG. 6 is disposed on front surface side 1a of cabinet 1, and inside air inlet 6 is disposed on rear side 1b of cabinet 1. The manner of operation of cooling device 3 will be described with reference to FIG. 7.

Firstly, the movement of outside air 23 is described. When outside air fan 14 is operated, cold outside air 23 indicated by a white arrow is sucked into cooling device 3 through outside air inlet 8. A pressure of outside air 23 is boosted by outside air fan 14, and outside air 23 flows into heat exchange element 11 through outside air ventilation port 15. Warm outside air 23 indicated by a black arrow which has passed through heat exchange element 11 flows into outside air chamber 12 through outside air ventilation port 16. Then, warm outside air 23 is discharged to an outside air space again through outside air outlet 9 provided in a lower surface of cooling device 3 shown in FIG. 3A.

On the other hand, when inside air fan 17 is operated, warm inside air 24 existing in the inside of cabinet 1 and indicated by a black arrow flows into the inside of cooling device 3 through inside air inlet 6. Then, a pressure of inside air 24 is boosted by inside air fan 17, and inside air 24 flows into the inside of heat exchange element 11 through second inflow port 11b of heat exchange element 11 shown in FIG. 3B. Cold inside air 24 indicated by a white arrow which has passed through heat exchange element 11 flows from heat exchange element 11 and, at the same time, is discharged into cabinet 1 again through inside air outlet 7.

In this exemplary embodiment, the inside of heat exchange element 11 shown in FIG. 3B is partitioned by thin plate bodies 25 such that inside air passages through which warm inside air 24 indicated by a black arrow passes and outside air passages through which cold outside air 23 indicated by a white arrow passes are alternately formed. Accordingly, heat exchange is performed between inside air 24 and outside air 23. That is, the heat exchange is performed between warm inside air 24 which receives heat generated by communication device 4 and cold outside air 23 so that inside air 24 is cooled and outside air 23 is warmed.

Cooled inside air 24 is blown out to front surface side 1a of cabinet 1. The internal printed circuit board of communication device 4 is disposed orthogonal to front cabinet door 2a and hence, inside air 24 in the inside of cabinet 1 flows to rear side 1b from front surface side 1a. Communication device 4 is not disposed on rear side 1b of cabinet 1 so that a chamber space through which inside air 24 passes is formed on rear side 1b of cabinet 1. Warm inside air 24 which receives heat generated by communication device 4 stagnates in the chamber space. Inside air fan 17 of cooling device 3 sucks warm inside air 24 stagnating in the chamber space. Sucked warm inside air 24 is cooled in the inside of cooling device 3.

In this manner, with respect to cooling device 3, the inside of cabinet 1 is divided by element casing 10 in the vertical direction. Inside air fan 17 and heat exchange element 11 are disposed on a cabinet 1 side, and outside air fan 14 is disposed on an outside air 23 side and hence, the attachment area of cooling device 3 is reduced. That is, heat exchange element 11 and outside air fan 14 are disposed in an overlapping manner as viewed from the cabinet 1 side and hence, the attachment area for attaching cooling device 3 to cabinet 1 is reduced.

Further, as shown in FIG. 3B, inside air fan rotation axis 17a and inside air suction direction 6a of inside air inlet 6 are disposed parallel to each other and hence, a thickness of inside air area 51 is reduced with reference to a fixing surface of cabinet 1 to which cooling device 3 is fixed. That is, a length of inside air fan 17 in the axial direction is smaller than a length of inside air fan 17 in the radial direction and hence, the thickness of inside air area 51 is reduced.

As shown in FIG. 5A, and FIG. 5B, outside air fan rotation axis 14a and outside air suction direction 8a of outside air inlet 8 are disposed parallel to each other and hence, a thickness of outside air area 52 is reduced with reference to a fixing surface of cabinet 1 shown in FIG. 3B to which cooling device 3 is fixed. That is, a length of outside air fan 14 in the axial direction is smaller than a length of outside air fan 14 in the radial direction and hence, the thickness of outside air area 52 is reduced.

As shown in FIG. 7, inside air outlet 7 is disposed on front surface side 1a of cabinet 1, and inside air inlet 6 is disposed on rear side 1b of cabinet 1 and hence, inside air 24 smoothly flows in cabinet 1 and is efficiently cooled. That is, inside air 24 flows from front surface side 1a to rear side 1b in the inside of cabinet 1, and flows from a rear side to a front surface side in the inside of cooling device 3. That is, the direction of the flow of inside air 24 which flows in the inside of cabinet 1 and the direction of flow of inside air 24 which flows in the inside of cooling device 3 are opposite to each other. Accordingly, the flow of inside air 24 forms a simple loop-shaped circulation air passage so that a pressure loss is suppressed to a small value whereby inside air 24 can be efficiently cooled.

As shown in FIG. 6, partition plate 19 which partitions between inside air outlet 7 and inside air inlet 6 is provided in cooling device 3 on a cabinet 1 side. With the provision of partition plate 19, shortcut of inside air 24 between inside air outlet 7 and inside air inlet 6 can be prevented in the inside of cabinet 1.

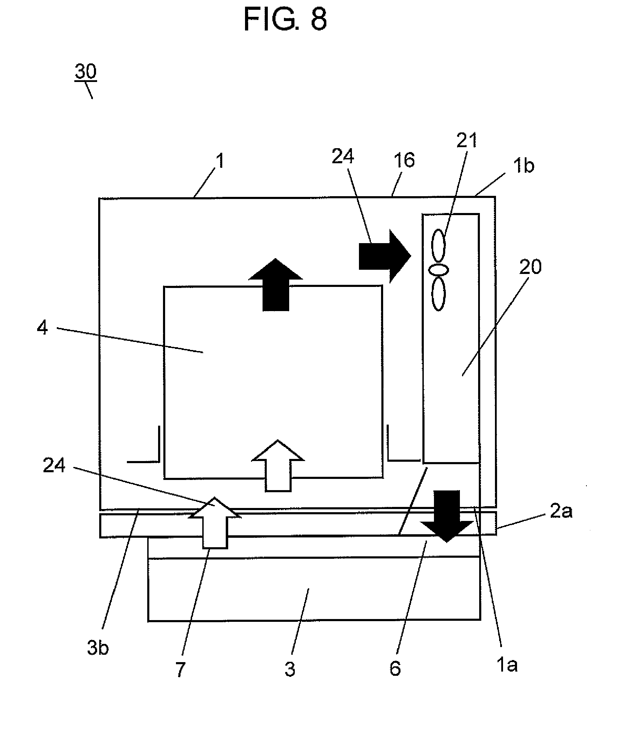

FIG. 8 is a schematic view showing the inside of the heating element housing device according to the exemplary embodiment of the present invention as viewed from above in the vertical direction in the case where the cooling device is attached to the cabinet 1 at a position different from the position described above. In heating element housing device 30 shown in FIG. 8, attachment surface 3b of cooling device 3 is disposed on front cabinet door 2a. Further, duct 20 which makes inside air 24 flow from rear side 1b to front surface side 1a is provided in the inside of cabinet 1. Duct 20 is provided on an inside air inlet 6 side as viewed from above. Duct 20 is connected to inside air inlet 6 of cooling device 3 on front surface side 1a when front cabinet door 2a is closed.

Due to such a configuration, inside air 24 blown out from inside air outlet 7 of cooling device 3 flows from front surface side 1a of cabinet 1 to rear side 1b of cabinet 1 while taking away heat generated by communication device 4. Inside air 24 on rear side 1b of cabinet 1 is sucked into duct 20 by operating inside air fan 17 shown in FIG. 3B, and flows into the inside of cooling device 3 through inside air inlet 6. That is, the flow of inside air 24a is formed into a simple loop-shaped circulation air passage by duct 20, and cooled inside air 24 is blown out from cooling device 3 such that cooled inside air 24 hits communication device 4. Accordingly, communication device 4 can be efficiently cooled.

With the provision of auxiliary inside air fan 21 in the inside of duct 20, a flow rate can be ensured corresponding to the increase of a pressure loss in duct 20 and hence, communication device 4 can be efficiently cooled.

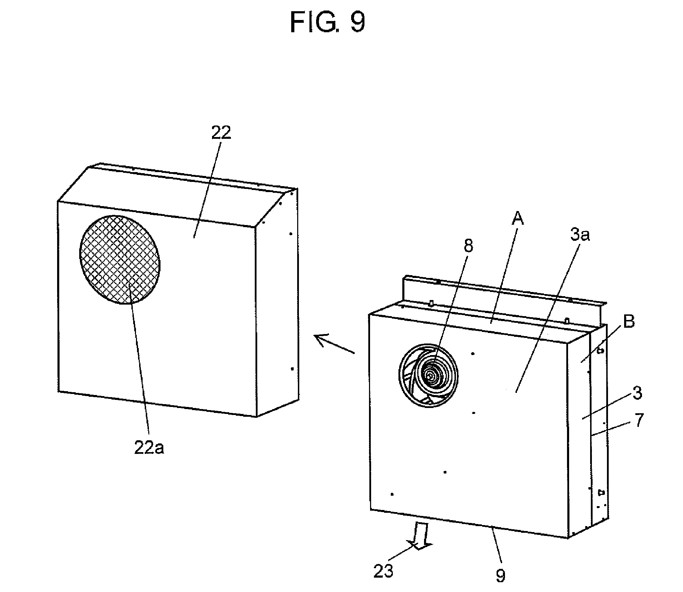

FIG. 9 is a perspective view of a cooling device body of the cooling device according to the exemplary embodiment of the present invention in a state where the outer cover is removed from cooling device. As shown in FIG. 9, outer cover 22 has air suction opening 22a at a position corresponding to outside air inlet 8. Although not shown in FIG. 9, outer cover 22 has a lower surface thereof opened so that outside air 23 blown out from outside air outlet 9 of cooling device 3 is discharged to an outside air space. Further, a top surface of outer cover 22 is inclined. A surface of cooling device 3 fixed to cabinet 1 shown in FIG. 4 has an approximately square shape.

Due to such a configuration, whichever surface of cooling device 3 adjacent to a fixing surface of cooling device 3 to be fixed to cabinet 1 is formed as a top surface, and outer cover 22 can be attached to cooling device 3. That is, although surface A of cooling device 3 is formed as the top surface of cooling device 3 in FIG. 9, surface B of cooling device 3 may be formed as the top surface of cooling device 3 by rotating cooling device 3 by 90 degrees. Also in such a case, outer cover 22 can be attached to cooling device 3 while forming the top surface by the inclined surface.

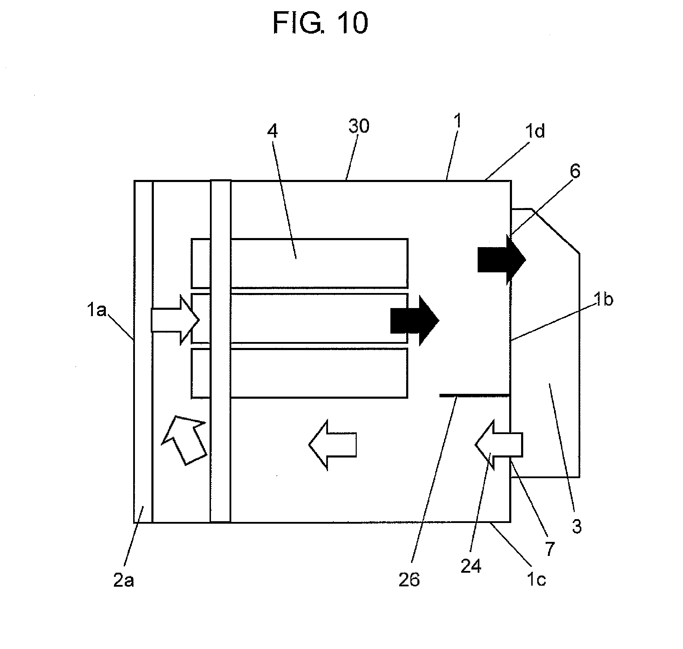

FIG. 10 is a schematic view showing the inside of the heating element housing device according to the exemplary embodiment of the present invention as viewed from the horizontal direction in the case where the cooling device is attached to the cabinet 1 at another position different from the position described above. FIG. 10 shows heating element housing device 30 where cooling device 3 is attached to a rear surface of cabinet 1 in a state where inside air inlet 6 is disposed on a top surface side 1d of cabinet 1 and inside air outlet 7 is disposed on a bottom surface side 1c of cabinet 1. As shown in FIG. 10, communication device 4 is provided in an upper space in the inside of cabinet 1, and a ventilation space is formed in a lower portion of cabinet 1.

Due to such a configuration, cooled inside air 24 blown out from inside air outlet 7 flows to front surface side 1a through the lower portion of cabinet 1. Inside air 24 is folded upward on front surface side 1a (front cabinet door 2a side) of cabinet 1. Then, inside air 24 passes through the inside of communication device 4 from front surface side 1a to rear side 1b thus cooling communication device 4, and inside air is warmed. Warmed inside air 24 which reaches rear side 1b of cabinet 1 is sucked into the inside of cooling device 3 again from inside air inlet 6 and is cooled by cooling device 3.

In this manner, the heating element housing device is configured such that the ventilation direction in the lower portion of cabinet 1 and the ventilation direction in the upper portion of cabinet 1 are opposite to each other. Due to such a configuration, a ventilation passage is simplified so that inside air 24 flows efficiently. Accordingly, communication device 4 can be efficiently cooled.

On a cabinet 1 side of cooling device 3, inside air outlet 7 and inside air inlet 6 are partitioned from each other by partition plate 19 as shown in FIG. 6. Due to such a configuration, shortcut of inside air 24 between inside air outlet 7 and inside air inlet 6 can be prevented in the inside of cooling device 3. Partition plate 26 shown in FIG. 10 also prevents shortcut of inside air 24 between inside air outlet 7 and inside air inlet 6 in the inside of cabinet 1. Partition plate 26 functions as a guide for guiding inside air 24 blown out from inside air outlet 7 to the lower space of cabinet 1.

### INDUSTRIAL APPLICABILITY

As has been described above, the cooling device and the heating element housing device equipped with the same according to the present invention are effectively applicable as a cooling installation for a base station for communication device and other outdoor equipment having a limited installation area.

### REFERENCE MARKS IN THE DRAWINGS

- 1: cabinet
- la: front surface side
- 1b: rear side
- 1c: bottom surface side
- 1d: top surface side
- 2a: front cabinet door
- 2b: side cabinet door
- 3: cooling device
- 3a: body case
- 3b: attachment surface
- 4: communication device
- 6: inside air inlet
- 6a: inside air suction direction
- 7: inside air outlet
- 8: outside air inlet
- 8a: outside air suction direction
- 9: outside air outlet
- 10: element casing
- 11: heat exchange element
- 11a: first inflow port
- 11b: second inflow port
- 12: outside air chamber
- 13: partition plate
- 14: outside air fan
- 14a: outside air fan rotation axis
- 15, 16: outside air ventilation port
- 17: inside air fan
- 17a: inside air fan rotation axis
- 18: packing
- 19, 26: partition plate
- 20: duct
- 21: auxiliary inside air fan
- 22: outer cover
- 22a: air suction opening
- 23: outside air
- 24: inside air
- 25: plate body
- 30: heating element housing device
- 51: inside air area
- 52: outside air area
- 53: utility pole

## Claims

1. A cooling device comprising:
a body case having an outside air inlet, an outside air outlet, an inside air inlet, and an inside air outlet;
an outside air fan and an inside air fan provided in an inside of the body case; and
a heat exchange element which performs heat exchange between outside air and inside air in the inside of the body case,
wherein the heat exchange element is formed by laminating a plurality of plate bodies at predetermined intervals,
the heat exchange element is held by an element casing which divides the inside of the body case into an inside air area into which the inside air is sucked and an outside air area into which the outside air is sucked,
the outside air inlet is provided in the outside air area,
the inside air inlet and the inside air outlet are provided in an attachment surface of the body case in the inside air area,
the outside air fan is disposed in the outside air area, and
the inside air fan adjacent to the inside air inlet and the heat exchange element adjacent to the inside air outlet are disposed in the inside air area.

2. The cooling device according to claim 1, wherein
the outside air fan includes a turbo centrifugal impeller, and a rotation axis of the outside air fan is disposed parallel to an outside air suction direction of the outside air inlet.

3. The cooling device according to claim 1, wherein
the inside air fan includes an axial impeller, and
a rotation axis of the inside air fan is disposed parallel to an inside air suction direction of the inside air inlet.

4. A heating element housing device having a cabinet on which the cooling device according to claim 1 is mounted with the attachment surface abutting on the cabinet, wherein
the inside air outlet is disposed on a front surface side of the cabinet, and the inside air inlet is disposed on a rear side of the cabinet.

5. A heating element housing device having a cabinet on which the cooling device according to claim 1 is mounted with the attachment surface abutting on the cabinet, wherein
the attachment surface is mounted on a front cabinet door, and
a duct connected to the inside air inlet is provided in (an inside of) the cabinet.

6. The heating element housing device according to claim 5, wherein an auxiliary inside air fan is provided in (an inside of) the duct.

7. A heating element housing device having a cabinet on which the cooling device according to claim 1 is mounted with the attachment surface abutting on the cabinet, wherein the inside air outlet is disposed on a bottom surface side of the cabinet, and the inside air inlet is disposed on a top surface side of the cabinet.
